# EUROPEAN PATENT APPLICATION

(11) **EP 2 083 453 A2**
(43) Date of publication of application: **29.07.2009**
(21) Application number: 08005869.6
(22) Date of filing: 27.03.2008
(51) Int. Cl.: H01L 33/00

(54) **Light emitting diode package**

(30) Priority: 28.01.2008 KR 20080001268 U
(71) Applicant: Alti-electronics Co., Ltd., Cheoin-gu, Yongin-si, Gyeonggi-do (KR)
(72) Inventor: Lee, Jin Won, Yongin-si Gyeonggi-do (KR); Park, Kyoung-II, Busanjin-gu Busan (KR); Kim, Sun-Hong, Nam-gu Incheon (KR)
(74) Representative: Grünecker, Kinkeldey, Stockmair & Schwanhäusser Anwaltssozietät

(57) **Abstract**

An LED package includes a housing, a substrate, a pad frame and an LED chip. The housing includes a plastic material, and has a recess with an opening at a top of the housing. The substrate includes substantially the same material with the housing. The pad frame includes conductive material, and is inserted on the substrate, and is fixed between the housing and the substrate. The LED chip is mounted on the pad frame and is disposed at a center of the recess. The housing is protruded and extended to a lower portion of the LED chip. Thicknesses of the housing's sidewalls facing to each other through the recess are substantially the same with each other.

## Description

### CROSS-REFERENCE TO RELATED APPLICATIONS

This application claims priority under 35 U.S.C. § 119 to Korean Utility Models Application No. 20-2008-0001268, filed on January 28, 2008 in the Korean Intellectual Property Office (KIPO), the contents of which are herein incorporated by reference in their entirety.

### BACKGROUND OF THE INVENTION

### 1. Field of the Invention

The present invention relates to a light-emitting diode ("LED") package. More particularly, the present invention relates to an LED package improving brightness.

### 2. Description of the Related Art

A light-emitting diode ("LED") is a kind of a semiconductor device converting electrical energy into optical energy, and is composed of semiconductor compounds emitting light having a specific wavelength according to an energy band gap. Recently, applications of the LED are varied, and the uses of the LED are increased. The LED is provided as a package according to the objects and the required shape. The LED could be manufactured as a top view type and a side view type according to the use.

In general, the LED package is manufactured by mounting an LED chip on a substrate or a lead frame and electrically connecting a device of the chip and an electrode pad. A housing is formed to protect the LED chip and the lead frame. However, the shape of the housing is formed thick by the interference of the lead frame at the side view LED package, and the thickness of the upper surface of the housing is non-symmetric by the interference. The loss of the light from the LED chip is increased by the reduced inner volume of the housing, so that the efficiency of the LED package is decreased.

### SUMMARY OF THE INVENTION

The present invention provides a light-emitting diode ("LED") package improving brightness and optical efficiency.

In one aspect of the present invention, an LED package includes a housing, a substrate, a pad frame and an LED chip. The housing includes a plastic material, and has a recess with an opening at a top of the housing. The substrate includes substantially the same material with the housing. The pad frame includes conductive material, and is inserted on the substrate, and is fixed between the housing and the substrate. The LED chip is mounted on the pad frame and is disposed at a center of the recess. The housing is protruded and extended to a lower portion of the LED chip. Thicknesses of the housing's sidewalls facing to each other through the recess are substantially the same with each other. The LED package may be a side view type.

An inner surface of the housing is inclined at a predetermined angle to have wider area at the opening of the housing than a bottom of the housing.

A thickness of the inner surface of the housing and a thickness of an outer surface of the housing may be increased constantly toward the bottom of the housing.

An inner surface of the housing may be coated with reflection material to reflect light upwardly.

The refection material may include aluminum, silver or plastic.

According to the present invention, a shape of light exiting part is changed, and an area is increased. Thus, a loss of the light is reduced, and an amount of the light is increased, so that brightness improves.

### BRIEF DESCRIPTION OF THE DRAWINGS

The above and other advantages of the present invention will become readily apparent by reference to the following detailed description when considered in conjunction with the accompanying drawings wherein:
FIG. 1 is a perspective view of a light-emitting diode ("LED") in accordance with an exemplary embodiment of the present invention;
FIG. 2 is a front view of an LED in accordance with an exemplary embodiment of the present invention;
FIG. 3 is a cross-sectional view of the LED in FIG. 2 taken along the line of I-I'; and
FIG. 4 is a cross-sectional view of the LED in FIG. 2 taken along the line of II-II'.

### DESCRIPTION OF THE EMBODIMENTS

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity.

It will be understood that when an element or layer is referred to as being "on," "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, the present invention will be described in detail with reference to the accompanying drawings.

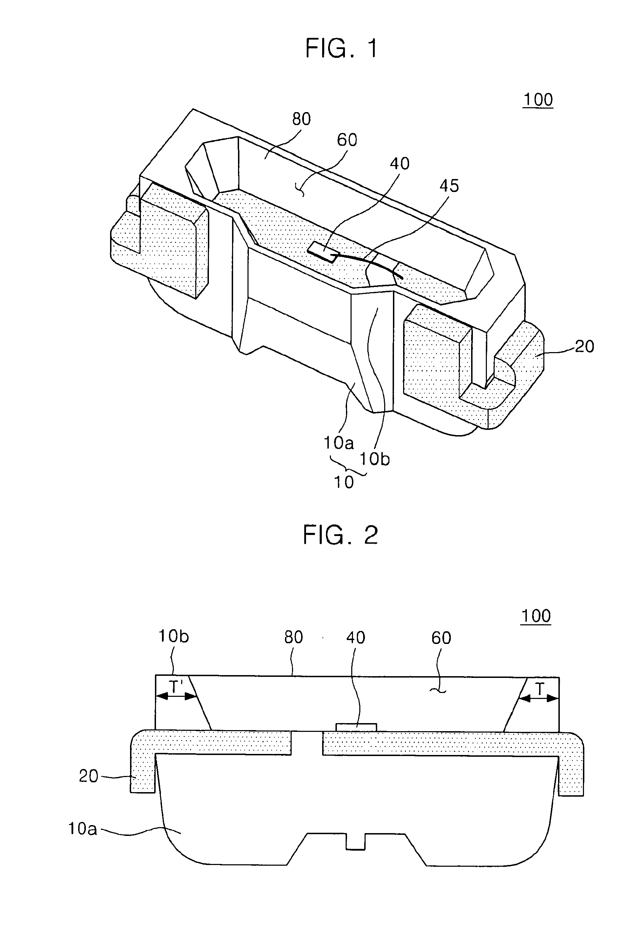

FIG. 1 is a perspective view of a light-emitting diode ("LED") in accordance with an exemplary embodiment of the present invention. FIG. 2 is a front view of an LED in accordance with an exemplary embodiment of the present invention.

Referring to FIGS. 1 and 2, a LED package 100 includes a package housing 10, a pad frame 20, an LED chip 40 and a molding part 80.

The package housing 10 may include a plastic material such as polycarbonate ("PC"), polycarbonate acrylonitrile butadiene styrene ("PCABS"), polyphthalamide ("PPA"), polybutylene terephthalate ("PBT"), nylon or insulation ceramic, and may be formed by a mold-injection method. Such housing formed by the mold-injection method may be easily applied to a small connecting part and space having a specific shape. When highly thermal conductive ceramics is applied, heats emitted from the LED chip 40, which generates light, are dissipated effectively.

The package housing 10 may include a substrate 10a and a housing 10b.

The substrate 10a may be formed as a plate shape, and a receiving recess is formed on an upper face of the substrate 10a. A pad frame 20 is received and combined at the receiving recess.

The housing 10b is combined with the substrate 10a, and the housing 10b surrounds the pad fame 20 on the substrate 10a, and forms a recess having an opening at an upper face of the package housing 10. The housing 10b protects and supports an LED chip 40 and the pad frame 20.

The recess 60 is space for receiving the LED chip 40, and thickness of the housing 10b facing through the recess 60 may be formed with substantially the same thickness of the recess 60.

An inner face of the housing 10b may be coated with a reflection material to irradiate light upwardly. Alternatively, the inner face of the housing 10b may be combined with a metallic reflection plate to function as a reflection plate. The reflection plate (not shown) reflects light emitted from the LED chip 40 to protect dispersion of the light. The light reflected by the reflection plate is refracted and dispersed through a polygonal shape and exits in a vertical direction. The reflection plate may include plastic such as polymethylmethacrylate ("PMMA") or resin, aluminum material, and metallic material coated by silver and metallic material coated by aluminum, and other metallic material being capable of reflection.

The pad frame 20 is formed on the substrate 10a, and formed by dividing the pad frames 20 into a plurality of areas electrically insulated by the insulated substrate 10a. Moreover, a part of the pad frame 20 may be exposed through the recess 60 of the housing 10b. The pad frame 20 may include metallic material having excellent electric conductivity and thermal conductivity. The pad frame 20 may include conductive material such as gold (Au), silver (Ag), copper (Cu) and so on.

Both of the pad frames 20 are disposed separately to face to each other. The pad frame 20 may be exposed through both sidewalls of the housing 30. The pad fame 20 exposed to outside functions as an electrode of the LED package 40. For example, an end portion of the pad frame 20 may be formed as a cathode, and the remaining end portion of the pad frame 20 may be formed as an anode. An end portion of an outside of the pad frame 20 may be connected to a printed circuit board ("PCB") (not shown), respectively.

The pad frame 20 exposed through the housing 10b is mounted on the LED chip 40, and the mounted LED chip 40 and the pad frame 20 are electrically connected to apply a voltage to the LED chip 40. The number of conductive lead may be decided according to the number of the LED chip 40, a mounting method and an electrical connecting method. The LED chip 40 is fixed by attaching at least one of the LED chip 40 to the pad frame 20. A terminal of the LED chip 40 may be electrically connected to the pad frame 20 with a wire 45, and the terminal of the LED chip 40 may be electrically connected by a flip-chip method. The LED chip 40 may be fixed on the substrate 10 by an adhering member such as an epoxy resin or a eutectic solder.

The LED chip 40 is applied with a general LED chip. For example, the LED chip 40 may include an LED chip with GaN series. The GaN series LED chip may emit white light by coating fluorescent material emitting light having wavelength of yellow color on the chip. A method for emitting white light using by fluorescent materials of red, green and blue colors may be used.

The molding part 80 is formed at housing 30 peripheral to the LED chip 40, and is filled with an encapsulant to protecting the LED chip 30 mounted at the pad frame 20. The encapsulant is formed on the LED chip 40, which is disposed at the recess 60. The encapsulant is filled with transparent material to protect the LED chip 40 and to change a light proceeding course, so that light emission efficiency may be improved. The encapsulant may include micelle, epoxy or silicon, and may include phosphors according to emitting light color of the LED chip 40 to make wavelength of the generated light longer when the phosphors are used. Epoxy resin and silicon resin, which are liquid state and not stiffed yet, are mixed to form micelle. The encapsulant material having the micelle may be form an encapsulant layer using a dispensing method.

Moreover, the LED package 100 of the embodiment may further include a lens on an upper portion of the molding part 80.

The lens may be formed as a concave shape, a flat shape and convex shape, and may include a charging material having fluorescent material when a white LED is implemented.

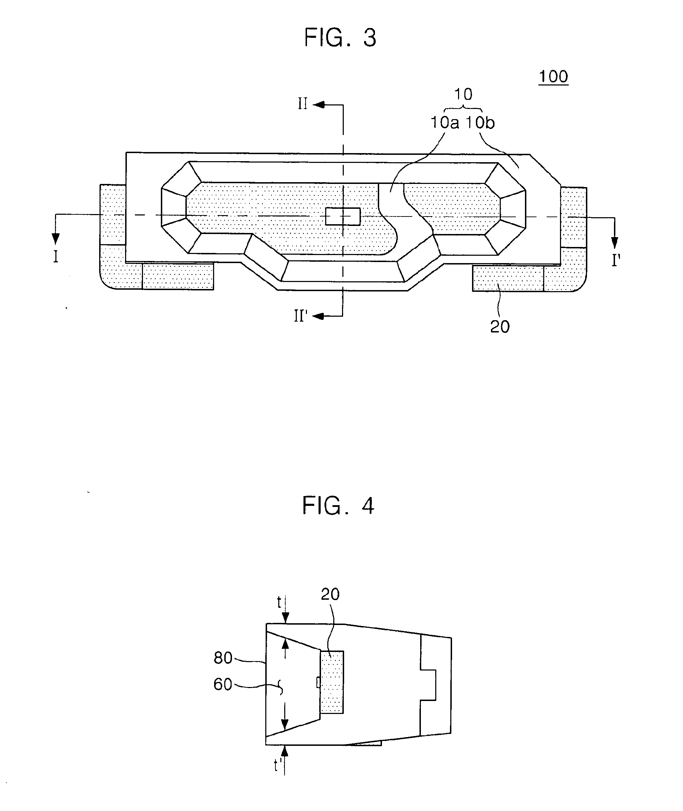

FIG. 3 is a cross-sectional view of the LED in FIG. 2 taken along the line of I-I'. FIG. 4 is a cross-sectional view of the LED in FIG. 2 taken along the line of II-II'.

Referring to FIGS. 3 and 4, the housing 10b supports to dispose the LED chip 40 in an inner center of the recess 60. A lower center portion of the housing 10b, at which the LED chip 40 is mounted, is extended and protruded. The housing 10b is formed at substantially the same height as the pad frame 20 to help a stable mount of the LED package 100.

Thicknesses of the housing 10b facing through the recess 60, at which the LED chip 40 is mounted, may be formed with substantially the same height.

The inner face of the housing 10b defining the recess 60 is formed to have a predetermined angle at sidewalls to have a wider entrance are of mounting space than a bottom area of the mounting space. Thus, the loss of light may reduced. The thickness of an inner surface and an outer surface of the housing 10b may be increased constantly toward the bottom of the housing 10b.

When the LED package 100 is mounted on the PCB (not shown), a first thickness T of the housing 10b protruded to the outside and a second thickness T' facing the first thickness T may be formed as substantially the same to support the protruded pad frame 20 and the package housing 10. A third thickness t and a fourth thickness t' facing the third thickness t may be formed as substantially the same to support the protruded pad frame 20 and the package housing 10.

The recess 60 reduces the loss of the light generated at the LED chip 40 by forming the opening area wider, thereby the light emitting further. A depth of the recess 60 may be a minimum depth to receive the LED chip 40.

In the present embodiment, the LED device of the side view type is applied. However, the LED device of the present embodiment may be implemented with an LED device of the top view type, a method applying to a flash and a power LED device for lighting.

Although the exemplary embodiments of the present invention have been described, it is understood that the present invention should not be limited to these exemplary embodiments but various changes and modifications can be made by one ordinary skilled in the art within the spirit and scope of the present invention as hereinafter claimed.

## Claims

1. A light-emitting diode ("LED") package comprising:
a housing including a plastic material and having a recess with an opening at a top of the housing;
a substrate including substantially the same material with the housing;
at least one pad frame including conductive material, and inserted on the substrate, and fixed between the housing and the substrate; and
an LED chip mounted on the pad frame and disposed at a center of the recess, and
wherein the housing is protruded and extended to a lower portion of the LED chip, and
wherein thicknesses of the housing's sidewalls facing to each other through the recess are substantially the same with each other.

2. The LED package of claim 1, wherein the LED package is a side view type.

3. The LED package of claim 1, wherein an inner surface of the housing is inclined at a predetermined angle to have wider area at the opening of the housing than at a bottom of the housing.

4. The LED package of claim 3, wherein a thickness of the inner surface of the housing and a thickness of an outer surface of the housing are increased constantly toward the bottom of the housing.

5. The LED package of claim 1, wherein an inner surface of the housing is coated with reflection material to reflect light upwardly.

6. The LED package of claim 5, wherein the refection material comprises aluminum, silver or plastic.
